# EUROPEAN PATENT SPECIFICATION

(11) **EP 2 085 494 B1**
(45) Date of publication and mention of the grant of the patent: **03.08.2011**
(21) Application number: 08101220.5
(22) Date of filing: 01.02.2008
(51) Int. Cl.: C23C 14/56

(54) **Twin-type coating device with improved separating plate**
Doppelbeschichtungsvorrichtung mit verbesserter Trennplatte
Dispositif de revêtement de type double doté d'une plaque de séparation améliorée

(43) Date of publication of application: 05.08.2009
(73) Proprietor: Applied Materials, Inc., Santa Clara, CA 95054 (US)
(72) Inventor: Wolf, Hans, 63526 Erlensee (DE); Heimel, Oliver, 34590 Wabern (DE); Krempel-Hesse, Jörg, 63683 Eckartsborn (DE); Fuchs, Frank, 63826 Geiselbach-Omersbach (DE)
(74) Representative: Lang, Christian

(56) References cited:
- WO-A-98/28461
- US-B1- 6 214 120

## Description

### BACKGROUND OF THE INVENTION

### FIELD OF THE INVENTION

The present invention refers to a coating device for coating of substrates, the device comprising at least two process chambers being disposed adjacent to each other, a separating plate between the two adjacent process chambers and pumping means for evacuating the process chambers.

### PRIOR ART

Coating devices for coating of substrates are well-known and widely used in industry for different applications. For example, architectural glass is used to be coated with heat insulation layers in order to improve heat conduction properties. Other examples for industrially used coatings are flat-panel TVs, computers displays or solar cells, which comprise flat panel substrates coated with different layers to achieve functional units to convert sunlight into electrical current or electrical signals into light emission.

Accordingly, the need for methods and devices which allow depositing of thin layers on large flat panel substrates is increasingly high. Thus, there is a desire for coating devices which allow fast, automated and effective coating processes with high accuracy of deposition.

Examples for different coating devices known in prior art can be found in DE 195 05 258 C2, DE 103 48 281 A1, DE 103 52 144 A1 and EP 171 73 39 A2.

DE 103 48 281 A1 discloses a vacuum processing device for flat, rectangular or square substrates with two vacuum chambers being separated by a handling mechanism for the substrates. The handling mechanism of DE 103 48 281 A1 allows to move the substrates from a lock to one of the process chambers without being exposed to the atmosphere.

A coating device comprising two process chambers is also disclosed in DE 195 52 258 C2. The two process chambers are located with distance to each other and are connected by a conduit which allows evacuation of the vacuum chambers by common pumping means.

Although, the above-mentioned coating devices having two process chambers may lead to sufficient coating results, one draw-back of the design of the coating devices mentioned above is handling time for moving the substrate from one process chamber to the other process chamber. Accordingly, it is known in prior art to provide so-called in-line coating devices in which the substrates are continuously moved from one process chamber to the next process chamber, without leaving the vacuum atmosphere provided along the passageway of substrates through the process chambers. Examples for this kind of coating devices are disclosed in DE 103 52 144 A1 and EP 171 73 39 A2.

The coating device of DE 103 52 144 A1 comprises different coating sections in which material is sputtered onto the substrate moving below or above a target of a sputter source or being stationary during the coating process. Between the coating sections as well as at the entrance or the exit of the coating device pump sections are provided to evacuate the passageway for the substrate as well as process chambers, in order to allow sputtering processes. Due to the arrangement of the pump sections between the coating sections, much space is required for such an apparatus.

EP 171 73 39 discloses a coating device of the in-line type which uses adjacent chambers or parallel passageways, respectively, one for the transport of the substrate through the process chamber and one for the return transport of masks and carriers as well as cleaning thereof. This design is very space-saving and an effectively working device. Such a design of an inline-coating device with parallel passageways through adjacent vacuum or process chambers can also be used for effectively increasing the throughput of such a device, when the second passageway is not only used for the return transport of masks or carriers, but for parallel coating processes.

US 6,214,120 B1 discloses a dual chamber compartment having a common separating wall between the two chambers. Within the very thick separating wall a conduit is provided which is connected to a common vacuum pump.

Although however, great efforts have already been made in the development of coating processes and the design of coating devices, there is still need for improvement.

### DISCLOSURE OF THE INVENTION

### OBJECT OF THE INVENTION

It is therefore an object of the present invention to provide a coating device having an increased efficiency and enabling at the same time high-quality depositions.

Accordingly, it is an object of the present invention to reduce the space required for such a coating device and to reduce material usage for producing such a device. Furthermore, such a device should be easy to manufacture and simple to operate as far as possible.

### TECHNICAL SOLUTION

The above-mentioned objects are achieved by a device having the features of claim 1. Preferred embodiments are subject matter of the dependant claims.

According to the invention, a coating device is provided which comprises at least two process chambers being disposed adjacent to each other and separated by a separating plate in between. This basic design of a twin-type coating device allows for simple construction of the process chambers as well as decreased effort for manufacture. In addition, such a design is space-saving.

The coating device of the present invention further comprises pumping means for evacuating the process chambers, since in many coating processes like sputtering reduced pressure or vacuum conditions are used.

According to the invention, the separating plate between the two process chambers comprises a conduit which is at the one end connected with the pumping means and which has at the other end at least one suction opening for both process chambers. However, at least two suction openings one for each process chamber for separately and independently exhausting the process chambers may be provided.

This design of the separating plate with the conduit integrated also allows for space-saving construction of the coating device, since the pumping means do not have to be disposed in separate pump sections which lead to an elongation of the overall device length, but allows placing the pumping means at arbitrary or user-defined locations.

In addition, the provision of a conduit at or in the separating plate leads to stiffening of the separating plate so that material usage for the separating plate can be reduced, as the separating plate can be formed with reduced thickness. Furthermore, utilization of the same pumping means for both process chambers may lead to similar pressure conditions in the adjacent process chambers so that the requirements for strength and stiffness of the separating plate can be further reduced.

The conduit can be arranged at or within the separating plate in different forms. For example, the conduit may be disposed at one side of the separating plate outside a plane of the separating plate being parallel to a main surface of the separating plate. However, it is also possible to dispose the conduit within the separating plate and especially in a recess of the separating plate or a space formed within a double-wall structure of the separating plate. In this case, a plane of the separating plate parallel to the main surface of the separating plate is cutting the conduit.

All the different designs with respect to the arrangement of the conduit lead to a reinforcement of the separating plate by the conduit, so that the thickness of the separating plate can be reduced.

Preferably, the conduit is disposed at the separating plate in a gastight manner in order to avoid mutual contamination of the process chambers through openings at the interface of conduit and separating plate. Depending on the way of arrangement of the conduit at the separating plate, the form of the conduit itself:may be different. When the conduit is arranged in a recess of the separating plate, the conduit can be formed as a tube without being affected by the separating plate. However, the conduit may be attached at the separating plate such that the separating plate is also separating the conduit into two halves. For example, this can be achieved by cutting the conduit along the length-direction and disposing the separating plate in the recess formed by the cut. Thus, two independent halves are formed with two independent suction openings at the respective end of the conduit.

The conduit may be fixed at the separating plate in any appropriate way. In particular the conduit may be connected to the separating plate by metallic continuity, for example through welding, or adhesive bond.

In another embodiment the conduit may have one common suction opening for both process chambers. This embodiment allows for quick pressure equalization between the two process chambers so that the stiffness and strength of the separating plate can be further reduced, since the separating plate has not to withstand great pressure differences.

As a consequence of the advantageous design of the separating plate having a conduit for evacuating the adjacent process chambers, the variability of positioning of the pumping means is increased. Accordingly, the pumping means may be located at the top of the process chamber or below the bottom of the process chamber instead of arranging them at the sidewalls of pump sections side by side to the coating means of the process chamber. Accordingly, the space required for the overall device can be significantly reduced.

Preferably, the coating device is designed as an in-line coating device with several process chambers being disposed side by side in a row to form a passageway for the substrates to be moved from one process chamber to the other. Hereby, process chamber comprises different kinds of chambers needed for carrying out the coating process as well as all handling steps therefore. The substrates may be transported in an upright position with a plane of the substrate parallel to the main surface of the substrate being in an angle range of ± 25° with respect to the vertical direction.

In addition, the coating device may comprise coating means for performing sputtering processes, plasma enhanced chemical vapour depositions (PECVD) and physical vapour depositions (PVD).

The conduits may be arranged in the process chamber side by side with the coating means, e.g. a twin-magnetron arrangement. This means, that with respect to the transport direction of the substrate, the suction openings of the conduit may respectively be arranged previous to the coating means and/or after the coating means. Preferably, the conduits or the suction openings, respectively, are disposed at the entrance and at the exit of each single process chamber.

In addition or alternatively the at least one conduit may be arranged opposite to the coating means, e.g. cathodes of a sputter apparatus or a PECVD device.

The conduits may have different lengths with respect to height of the process chamber. Accordingly, the conduits may cover the whole height of the process chamber or of the separating plate, respectively, or parts thereof. The height is defined in vertical direction. Thus, very short conduits with almost no extension from the pumping means located above or below the device up to very long conduits, the length of which being identical to the height of the process chamber or the separating plate, may be used.

The conduits may also comprise several suction openings distributed over the length of the conduit. These suction openings may be equipped with closures to close or open the suction openings according to the specific requirements. In addition, the suction openings may comprise orifice plates to influence gas flow.

Preferably, the conduits extend over different parts of the height of the process chamber or the separating plate, in order to achieve good evacuation of the process chamber. This can be achieved by providing suction openings in both, the upper and the lower areas of the process chamber. Accordingly, the conduits may extend over more than half or more than two-thirds of the height of the process chamber or less than half or one-third of the height of the process chamber. Moreover, suction openings may be provided alternately in a lower and an upper area of the process chamber along the passageway of the substrate or in both areas at a common conduit.

### SHORT DESCRIPTION OF FIGURES

Further advantages, features and characteristics of the present invention will be described in more detail with respect to the attached drawings which show in a completely schematic manner in
Fig. 1 a perspective view of one part of an embodiment of the present invention;
Fig. 2 a lateral view of the separating plate of the device of Fig. 1;
Fig. 3 a cross-section of the separating wall shown in Fig. 2 along the intersecting line indicated by the arrows in Fig. 2;
Fig. 4 a cross-section of another embodiment of a separating plate similar to Fig. 3; and in
Fig. 5 a cross-section of a third embodiment of a separating plate.

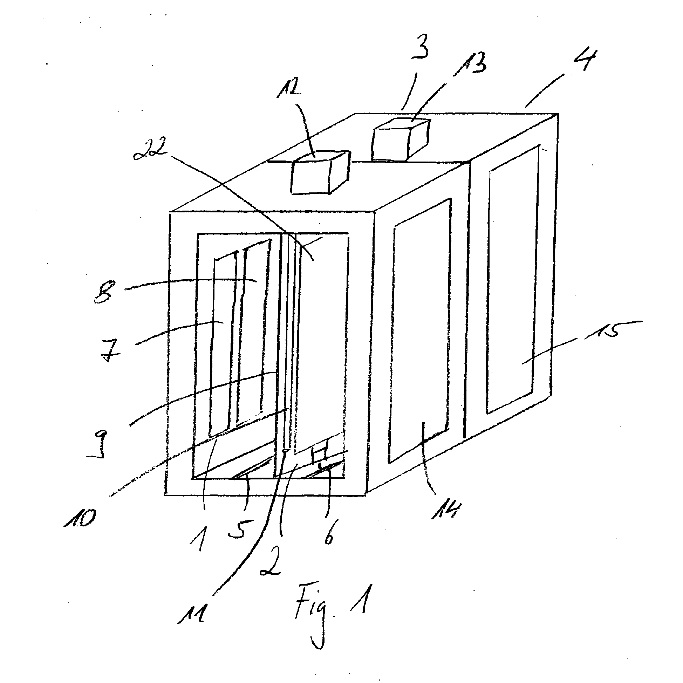

Figure 1 shows in a perspective view in a pure schematic illustration a part of an inventive coating device with four process chambers 1 to 4. The process chambers may also be designated as compartments or process compartments. Two process chambers, namely process chambers 1 and 2 as well as process chambers 3 and 4 are disposed adjacent to each other with the back-side of each process chamber as the common side and thus form in a back-to-back arrangement a twin process chamber.

According to the embodiment shown in figure 1, each couple of process chambers 1 and 2 is disposed side by side to the next couple of process chambers 3 and 4. Although there are only shown four process chambers in figure 1, a man skilled in the art will understand that several couples of process chambers 1, 2 and 3, 4 with their back-sides abutting each other may be aligned one after the other. Thus, the process chambers disposed in a row, like process chambers 2 and 4 as well as process chambers 1 and 3 define passage ways 5 and 6 along which the substrates 22 may be moved. Accordingly, twin process chambers 1, 2 and 3, 4 define two parallel passageways 5 and 6.

The substrates 22, which are preferably large, flat panels like architectural glass plates or display screens can be moved along the passage ways 5, 6 through the process chambers 2 and 4 or 1 and 3, respectively by means of movable substrate carriers (not shown).

The process chambers 1 and 2 as well as the process chambers 3 and 4 having their back-sides adjacent to each other are each separated by a separating plate 9.

Opposing to the separating plate 9, coating means, like twin-magnetron electrodes 7, 8 are located. For simple mounting of the coating means 7, 8, process chambers 1 to 4 comprise mounting doors 14, 15 for easy access to the process chamber.

The process chambers may be designed as modules, for example a module comprising two process chambers, namely process chamber 1 and 2 or 3 and 4. Accordingly, the process chambers or twin process chambers forming one module may be designed identically, so that the complete coating device can be set up by user-defined configuration of identical modules only adapted with additional equipment depending on the specific coating requirements.

Since the coating processes performed in the process chambers 1 to 4, e.g. sputtering processes, need vacuum conditions, process chambers 1 to 4 comprise pumping means 12, 13 like turbo-pumps.

The pumping means 12, 13 of the embodiment shown in figure 1 are located on top of the coating device. However, it is also possible to arrange the pumping means 12, 13 below the process chambers 1 to 4.

The pumping means 12, 13 are connected to conduits 10, one of which is shown in process chamber 2 of figure 1. The conduit 10 is extending from the pumping means 12 into process chamber 2 and comprises a suction opening 11 at the end opposing the end which is connected to the turbo-pump 12.

By means of the suction opening 11 and the conduit 10 gas or air being present in process chamber 2 may be evacuated by pumping means 12.

As shown in the embodiment of figure 1, the conduit 10 is extending over more than two-thirds of the height of the process chamber 2, with the height being defined as the vertical direction. Thus, by pumping means 12 and conduit 10 gas or air from the bottom area of the process chamber 2 may be exhausted, too.

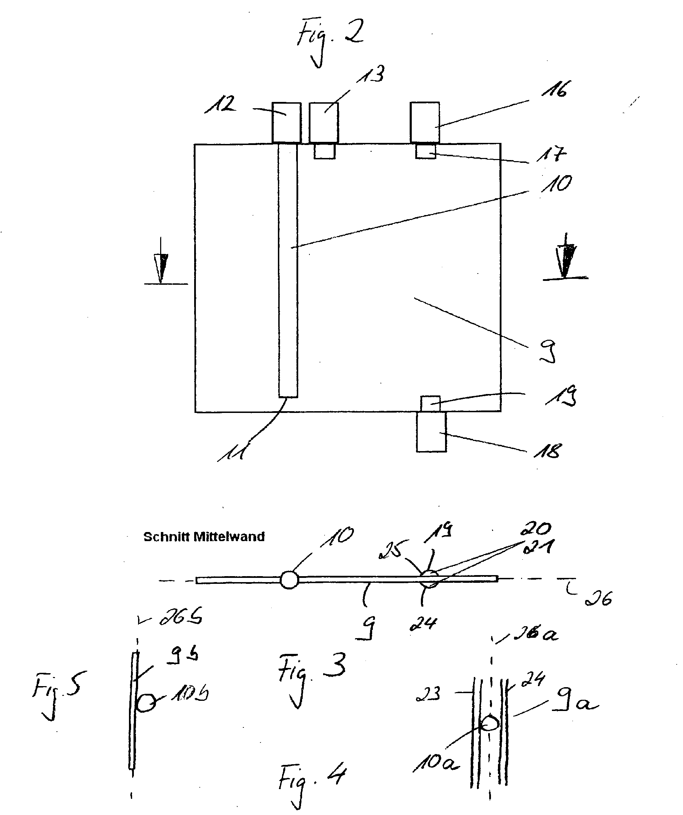

Figure 2 shows a lateral view of the separating plate 9, in order to demonstrate the design of the separating plate 9 and the different possibilities with respect to the arrangement of pumping means as well as conduits.

As can be seen in figure 2, one possibility for arranging conduit 10 is to provide a long tube extending from the top of the process chamber or the top of the separating plate 9 ,respectively, to an area near the bottom of the process chamber. This is a preferred embodiment, when the space conditions below the coating device or process chamber, respectively, is thus restricted not to allow disposing of pumping means.

In case, where enough space for providing pumping means below and above the process chamber is available and if it is not important to have a suction opening at a specific place of the process chamber, it may be sufficient to have only short conduits, like the conduits 17 and 19, extending only over a small part of the height of the separating plate, which is also defined as the vertical direction.

Accordingly, the embodiment shown in figure 2 comprises three pumping means 12, 13 and 16 above the process chamber or at the top of the separating plate, respectively, as well as fourth pumping means 18 below the process chamber or at the bottom of the separating plate 9, respectively. The pumping means 13, 16 and 18 are connected to short conduits, like conduits 17 and 19.

The pumping means 12, 13, 16 and 18 may also be aligned vertically, as shown in figure 2, when the inlet openings are connected straight ahead with the respective end of the conduits 10, 17, 19. Further, it is also possible to arrange the pumping means in a horizontal manner, so that the inlet opening of the pumping means 12, 13, 16 and 18 has to be connected to the conduits 10, 17, 18 by an elbow.

Figure 3 shows a cross-sections along the intersecting line indicated by the arrows in figure 2.

Figure 3 discloses that the conduit 10, 19 may be fixed to the separating plate 9 in different ways. The conduit 10 is disposed in a recess of separating plate 9. The conduit 10 is formed by a tube disposed in the recess and air-tightly fixed to the separating plate 9, e.g. by welding. Further, other forms of fixing the conduit 10 to the separating plate 9 may be used, like form fit, adhesive bond or frictional connection.

Due to the arrangement of the tube of the conduit 10 in the recess of separating plate 9, a common suction opening 11 at the end of the conduit 10 is formed for both process chambers neighbouring the separating plate 9. Accordingly, the pressure conditions are almost the same on both sides of the separating plate 9, i.e. in both process chambers abutting on the separating plate 9.

Due to the fixture of conduit 10 to the separating plate 9, the separating plate 9 is stiffened, so that a separating plate having a small thickness can be used. In addition, the thickness of the separating plate 9 can be reduced, since the pressure conditions are almost equal on both sides of the separating plate 9 due to the common suction opening 11.

A different form of arrangement of the conduit is shown with respect to conduit 19. Conduit 19 is separated by the separating plate 9 in two halves 20 and 21 with independent suction openings 24 and 25. Accordingly, valves or flaps (not shown) may be disposed in the halves 20 and 21 of the conduit 19, in order to enable closing of one of the suction openings 24 or 25. Accordingly, the process chambers being adjacent to the separating plate 9 can be evacuated separately. However, the design of conduit 19 is also stiffening the separating plate 9, in particular when conduit 19 is extending over more than a small part of the height of the separating plate 9 as shown in figure 2.

Figures 4 and 5 show additional embodiments of separating plates 9a or 9b, respectively, with different arrangements of conduits 10a or 10b.

According to the embodiment of figure 4, the separating plate 9a is formed by a two-wall construction comprising the walls 23 and 24, which are arranged in a distance to each other, so that a space is defined in which conduit 10a can be incorporated. At the suction end of conduit 10a, two elbows may be disposed, each having a suction opening for both of the process chambers on both sides of the separating plate 9a.

According to figure 5, the conduit 10b is attached to one side of the separating plate 9b. This is also an embodiment which contributes to stiffening of the separating plate 9b. However, this embodiment is simpler to manufacture, since it is not necessary to cut a recess in the separating plate 9b. The opening has to be formed at the suction end of conduit 10b into the separating plate 9b in order to allow the pumping means connected to the conduit 10b to evacuate both process chambers on both sides of the separating plate 9b.

As can be seen from figures 3 to 5, conduits 10, 10a or 10b, respectively, may be arranged such at the separating plate 9, 9a or 9b, respectively, so that the conduit is incorporated into the separating plate or attached to the separating plate. Accordingly, plane 26 of the separating plate 9 being parallel to the main surface of the separating plate is cutting the conduits 10 and 19 similar to the plane 26a of the separating plate 9a with respect to conduit 10a. Further, in the embodiment of figure 5, plane 26b of separating plate 9b does not cut conduit 10b.

Although, the present invention is described in detail with respect to the embodiments, it is evident for a man skilled in the art, that the invention is not restricted to these embodiments, but modifications and amendments are possible, with respect to a different combination of all the features disclosed in the specification or by omitting one of the features of the embodiments without leaving the scope of the present invention which is defined by the attached claims. In particular, the present invention comprises all possible combinations of all claims, even if single claims are only referred to other single claims.

## Claims

1. Coating device for coating of substrates comprising
at least two process chambers (1, 2, 3, 4) being disposed adjacent to each other,
a separating plate (9) between the two adjacent process chambers, and
pumping means (12, 13) for evacuating the process chambers, wherein the separating plate (9) comprises a conduit having at least two ends, one end of which is connected with the pumping means and the other end has at least one suction opening for at least one of the process chambers
**characterized in that**
the separating plate is reinforced by the conduit (10).

2. Coating device according to claim 1,
**wherein**
the conduit (10) is disposed at one side of the separating plate outside a plane of the separating plate being parallel to a main surface of the separating plate.

3. Coating device according to claim 1,
**wherein**
the conduit (10) is disposed within the separating plate, with the conduit cutting a plane of the separating plate.

4. Coating device according to any of the preceding claims,
**wherein**
the separating plate (9a) comprises a double wall structure.

5. Coating device according to any of the preceding claims,
**wherein**
the conduit (10) is disposed in a recess of the separating plate.

6. Coating device according to any of the preceding claims,
**wherein**
the conduit is disposed at the separating plate in a gastight manner.

7. Coating device according to any of the preceding claims,
**wherein**
the conduit (19) is separated by the separating plate in two independent halves.

8. Coating device according to any of the preceding claims,
**wherein**
the conduit comprises at least two independent suction openings, one for each process chamber.

9. Coating device according to any of the preceding claims 1 to 7,
**wherein**
the conduit comprises at least one common suction opening for adjacent process chambers.

10. Coating device according to any of the preceding claims,
**wherein**
the pumping means (13, 13) comprise at least one of turbo pumps and roots pumps.

11. Coating device according to claim 1,
**wherein**
the pumping means (12, 13, 18) are located on the top and/or below the bottom of the process chamber.

12. Coating device according to any of the preceding claims,
**wherein**
the coating device is an in-line coating device with several process chambers (1, 2, 3, 4) being disposed side by side in a row to be passed by the substrate one after the other.

13. Coating device according to claim 12,
**wherein**
the conduit is disposed at at least one area of the separating plate being near the neighboring process chamber.

14. Coating device according to any of the preceding claims,
**wherein**
the process chamber comprises at least one coating means, with at least one conduit being disposed laterally offset to the coating means.

15. Coating device according to claim 12,
**wherein**
transport means (5, 6) are provided for defining a passage way for the substrates to be coated through the row of process chambers, with at least one coating means and at least one conduit being arranged along the passage way through one process chamber one after the other.

16. Coating device according to any of the preceding claims,
**wherein**
the conduit (10) extends over more than half, especially more than two-thirds of the height of the process chamber.

17. Coating device according to any of the preceding claims,
**wherein**
the conduit extends over less than half, especially less than one-third of the height of the process chamber.

18. Coating device according to any of the preceding claims,
**wherein**
transport means (5, 6) are provided for transporting large flat panel substrates to be coated in an upright position with the plane of the substrate being aligned to the vertical direction within an angle range of -25° to 25° to the vertical direction.

19. Coating device according to any of the preceding claims,
**wherein**
coating means (7, 8) are provided in the process chamber comprising means for performing at least one out of the group comprising sputtering, plasma enhanced chemical vapour deposition (PECVD) and physical vapour deposition (PVD).

20. Coating device according to any of the preceding claims,
**wherein**
coating means are provided at the side opposing the separating plate.

## Patentansprüche

1. Beschichtungsapparatur zum Beschichten von Substraten, mit mindestens zwei Prozesskammern (1, 2, 3, 4), die benachbart zueinander angeordnet sind, einer Trennplatte (9) zwischen den zwei benachbarten Prozesskammern, und
einer Pumpeinrichtung (12,13), um die Prozesskammern zu evakuieren, wobei die Trennplatte (9) ein Leitung umfasst, die mindestens zwei Enden hat, von denen ein Ende mit der Pumpeinrichtung verbunden ist und das andere Ende hat mindestens eine Absaugöffnung für mindestens eine der Prozesskammern
**dadurch gekennzeichnet, dass**
die Trennplatte durch die Leitung (10) verstärkt wird.

2. Beschichtungsapparatur nach Anspruch 1,
**bei welcher**
die Leitung (10) an einer Seite der Trennplatte außerhalb einer Ebene der Trennplatte parallel zu einer Hauptfläche der Trennplatte angeordnet ist.

3. Beschichtungsapparatur nach Anspruch 1,
**bei welcher**
die Leitung (10) in der Trennplatte angeordnet ist, wobei die Leitung eine Ebene der Trennplatte schneidet.

4. Beschichtungsapparatur nach einem der vorherigen Ansprüche,
**bei welcher**
die Trennplatte (9A) eine Doppelwandstruktur aufweist.

5. Beschichtungsapparatur nach einem der vorherigen Ansprüche,
**bei welcher**
die Leitung (10) in einer Ausnehmung der Trennplatte angeordnet ist.

6. Beschichtungsapparatur nach einem der vorherigen Ansprüche,
**bei welcher**
die Leitung an der Trennplatte in einer gasdichten Art und Weise angeordnet ist.

7. Beschichtungsapparatur nach einem der vorherigen Ansprüche,
**bei welcher**
die Leitung (19) durch die Trennplatte in zwei unabhängige Hälften geteilt wird.

8. Beschichtungsapparatur nach einem der vorherigen Ansprüche,
**bei welcher**
die Leitung mindestens zwei unabhängige Ansaugöffnungen umfasst, eine für jede Prozesskammer.

9. Beschichtungsapparatur nach einem der Ansprüche 1 bis 7,
**bei welcher**
die Leitung wenigstens eine gemeinsame Ansaugöffnung für benachbarte Prozesskammern umfasst.

10. Beschichtungsapparatur nach einem der vorherigen Ansprüche,
**bei welcher**
die Pumpeinrichtung (13, 13) wenigstens eine Turbopumpe oder Drehschieberpumpe umfasst.

11. Beschichtungsapparatur nach Anspruch 1,
**bei welcher**
die Pumpeinrichtung (12, 13,18) oberhalb und/oder unterhalb der Prozesskammern angeordnet ist.

12. Beschichtungsapparatur nach einem der vorherigen Ansprüche,
**bei welcher**
die Beschichtungsapparatur ein Reihen-Beschichtungsapparatur mit mehreren Prozesskammern (1, 2,3 ,4) ist, die Seite an Seite in einer Reihe angeordnet sind, um eine nach der anderen von dem Substrat durchlaufen zu werden.

13. Beschichtungsapparatur nach Anspruch 12,
**bei welcher**
die Leitung in wenigstens einem Bereich der Trennplatte angeordnet ist, der sich nahe der benachbarten Prozesskammer befindet.

14. Beschichtungsapparatur nach einem der vorherigen Ansprüche,
**bei welcher**
die Prozesskammer wenigstens eine Beschichtungsvorrichtung umfasst, wobei die mindestens eine Leitung mit einem seitlichen Versatz gegenüber der Beschichtungsvorrichtung angeordnet ist.

15. Beschichtungsapparatur nach Anspruch 12,
**bei welcher**
Transportvorrichtungen (5, 6) vorgesehen sind, um einen Transportpfad für die Substrate, die beschichtet werden sollen, durch die Reihe der Prozesskammern zu definieren, wobei mindestens eine Beschichtungsvorrichtung und mindestens eine Leitung eine nach der anderen entlang des Transportpfads durch eine Prozesskammer angeordnet sind.

16. Beschichtungsapparatur nach einem der vorherigen Ansprüche,
**bei welcher**
die Leitung (10) sich über mehr als die Hälfte, insbesondere mehr als zwei Drittel, der Höhe der Prozesskammer erstreckt.

17. Beschichtungsapparatur nach einem der vorherigen Ansprüche,
**bei welcher**
die Leitung sich über weniger als die Hälfte, insbesondere weniger als ein Drittel, der Höhe der Prozesskammer erstreckt.

18. Beschichtungsapparatur nach einem der vorherigen Ansprüche,
**bei welcher**
Transportvorrichtungen (5,6) vorgesehen sind, um große, flache Plattensubstrate, die beschichtet werden sollen, in einer aufrechten Position zu transportieren, wobei die Ebene der Substrate gegenüber der vertikalen Richtung innerhalb eines Winkelbereichs von -25° bis +25° zur vertikalen Richtung ausgerichtet sind.

19. Beschichtungsapparatur nach einem der vorherigen Ansprüche,
**bei welcher**
eine Beschichtungseinrichtung (7, 8) in der Prozesskammer vorgesehen ist und Mittel umfasst, um wenigstens einen Vorgang aus der Gruppe auszuführen, die Kathodenzerstäubung, plasmaunterstützte chemische Gasphasenabscheidung (PECVD) und physikalische Gasphasenabscheidung (PVD) umfasst.

20. Beschichtungsapparatur nach einem der vorherigen Ansprüche,
**bei welcher**
Beschichtungseinrichtungen an gegenüberliegenden Seiten der Trennplatte vorgesehen sind.

## Revendications

1. Dispositif de revêtement pour revêtir des substrats comprenant au moins deux chambres de traitement (1, 2, 3, 4) qui sont placées adjacentes l'une par rapport à l'autre,
une plaque de séparation (9) entre les deux chambres de traitement adjacentes et
des moyens de pompage (12, 13) pour faire le vide des chambres de traitement, la plaque de séparation (9) comprenant un conduit ayant au moins deux extrémités, l'une des extrémités étant reliée aux moyens de pompage et l'autre extrémité ayant au moins une ouverture d'aspiration pour au moins l'une des chambres de traitement,
**caractérisé en ce**
**que** la plaque de séparation est renforcée par le conduit (10).

2. Dispositif de revêtement selon la revendication 1
dans lequel
le conduit (10) est placé sur un côté de la plaque de séparation à l'extérieur d'un plan de la plaque de séparation qui est parallèle à une surface principale de la plaque de séparation.

3. Dispositif de revêtement selon la revendication 1
dans lequel
le conduit (10) est placé à l'intérieur de la plaque de séparation avec le conduit qui coupe un plan de la plaque de séparation.

4. Dispositif de revêtement selon l'une quelconque des revendications précédentes
dans lequel
la plaque de séparation (9a) comprend une structure à double paroi.

5. Dispositif de revêtement selon l'une quelconque des revendications précédentes
dans lequel
le conduit (10) est placé dans un évidement de la plaque de séparation.

6. Dispositif de revêtement selon l'une quelconque des revendications précédentes
dans lequel
le conduit est placé sur la plaque de séparation d'une manière étanche au gaz.

7. Dispositif de revêtement selon l'une quelconque des revendications précédentes
dans lequel
le conduit (19) est séparé en deux moitiés indépendantes par la plaque de séparation.

8. Dispositif de revêtement selon l'une quelconque des revendications précédentes
dans lequel
le conduit comprend au moins deux ouvertures d'aspiration indépendantes, une pour chaque chambre de traitement.

9. Dispositif de revêtement selon l'une quelconque des revendications précédentes 1 à 7
dans lequel
le conduit comprend au moins une ouverture d'aspiration commune pour des chambres de traitement adjacentes.

10. Dispositif de revêtement selon l'une quelconque des revendications précédentes
dans lequel
les moyens de pompage (12, 13) comprennent au moins l'une des pompes, turbopompe et pompe Roots.

11. Dispositif de revêtement selon l'une quelconque des revendications précédentes
dans lequel
les moyens de pompage (12, 13, 18) sont situés sur le dessus et/ou en dessous du fond de la chambre de traitement.

12. Dispositif de revêtement selon l'une quelconque des revendications précédentes
dans lequel
le dispositif de revêtement est un dispositif de revêtement en ligne avec plusieurs chambres de traitement (1, 2, 3, 4) qui sont placées l'une à côté de l'autre en une rangée par lesquelles le substrat doit passer l'une après l'autre.

13. Dispositif de revêtement selon la revendication 12
dans lequel
le conduit est placé sur au moins une zone de la plaque de séparation qui est près de la chambre de traitement voisine.

14. Dispositif de revêtement selon l'une quelconque des revendications précédentes
dans lequel
la chambre de traitement comprend au moins un moyen de revêtement avec au moins un conduit qui est placé décalé latéralement par rapport au moyen de revêtement.

15. Dispositif de revêtement selon la revendication 12
dans lequel
des moyens de transport (5, 6) sont prévus pour définir une voie de passage pour les substrats à revêtir à travers la rangée de chambres de traitement avec au moins un moyen de revêtement et au moins un conduit disposé le long de la voie de passage qui passe par une chambre de traitement l'une après l'autre.

16. Dispositif de revêtement selon l'une quelconque des revendications précédentes
dans lequel
le conduit (10) s'étend sur plus de la moitié, en particulier sur plus des deux tiers de la hauteur de la chambre de traitement.

17. Dispositif de revêtement selon l'une quelconque des revendications précédentes
dans lequel
le conduit s'étend sur moins de la moitié, en particulier sur moins d'un tiers de la hauteur de la chambre de traitement.

18. Dispositif de revêtement selon l'une quelconque des revendications précédentes
dans lequel
des moyens de transport (5, 6) sont prévus pour transporter de grands substrats plats en panneaux à revêtir en une position debout avec le plan du substrat qui est aligné par rapport au sens vertical dans une plage angulaire de -25° à 25° par rapport au sens vertical.

19. Dispositif de revêtement selon l'une quelconque des revendications précédentes
dans lequel
des moyens de revêtement (7, 8) sont prévus dans la chambre de traitement qui comprennent des moyens pour réaliser au moins l'un des procédés du groupe comprenant la pulvérisation cathodique, le procédé de dépôt chimique en phase vapeur assisté par plasma (PECVD) et le procédé de dépôt en phase vapeur par procédé physique (PVD).

20. Dispositif de revêtement selon l'une quelconque des revendications précédentes
dans lequel
des moyens de revêtement sont prévus sur le côté en face de la plaque de séparation.
